# EUROPÄISCHE PATENTSCHRIFT

(11) **EP 1 464 791 B1**
(45) Veröffentlichungstag und Bekanntmachung des Hinweises auf die Patenterteilung: **10.12.2008**
(21) Anmeldenummer: 03006650.0
(22) Anmeldetag: 25.03.2003
(51) Int. Cl.: F01D 5/00, B23P 6/00, C30B 29/52

(54) **Verfahren und Vorrichtung zur Herstellung einer Turbinenkomponente**
Process and apparatus for manufacturing a turbine component
Procédé et appareillage pour la fabrication d'un élément d'une turbine

(43) Veröffentlichungstag der Anmeldung: 06.10.2004
(73) Patentinhaber: SIEMENS AKTIENGESELLSCHAFT, 80333 München (DE)
(72) Erfinder: Bostanjoglo, Georg, Dr., 12161 Berlin (DE); Cox, Nigel-Philip, 10119 Berlin (DE); Wilkenhöner, Rolf, Dr., 10589 Berlin (DE)

(56) Entgegenhaltungen:
- EP-A- 0 815 993
- WO-A-99/21680
- US-A- 6 024 792
- US-B1- 6 325 871
- US-B1- 6 331 217

## Beschreibung

Die Erfindung betrifft ein Verfahren zur Herstellung einer Turbinenkomponente wenigstens aus einem Basisteil und Aufbaumaterial, aufweisend die Schritte: Bereitstellen des Basisteils, Aufbringen des Aufbaumaterials auf das Basisteil, Überführen des Aufbaumaterials mindestens in einem an das Basisteil grenzenden Teilbereich von einem ersten Zustand in einen festen zweiten Zustand. Weiter betrifft die Erfindung eine Vorrichtung zur Herstellung einer Turbinenkomponente wenigstens aus einem Basisteil und Aufbaumaterial, aufweisend: eine Halterung zum Bereitstellen des Basisteils, eine Aufbringvorrichtung zum Aufbringen des Aufbaumaterials auf das Basisteil und zum Überführen des Aufbaumaterials mindestens in einen an das Basisteil grenzenden Teilbereich von einem ersten Zustand in einen festen zweiten Zustand. Die Erfindung führt auch auf eine Verwendung der Vorrichtung und auf eine Turbinenkomponente.

Die US-PS 6,024,792 zeigt das Auftragsschweissen bei einkristallinen Strukturen, bei dem mittels Pulverzufuhr neue Schichten auf einem Substrat erzeugt werden.

Turbinen werden in vielen Bereichen zum Antrieb von Generatoren oder von Arbeitsmaschinen eingesetzt. Dabei wird der Energieinhalt eines unter hohem Druck und unter hoher Temperatur stehenden Arbeitsmediums zur Erzeugung einer Rotationsbewegung einer Turbinenwelle benutzt, indem das Arbeitsmedium über die Turbine geführt wird, wobei es sich arbeitsleistend entspannt. Zur Erzeugung der Rotationsbewegung der Turbinenwelle sind eine Anzahl von üblicherweise in Schaufelgruppen oder Schaufelreihen ringförmig zusammengefasste Laufschaufeln am Außenumfang der Welle angeordnet, welche Laufschaufeln über einen Impulsübertrag aus dem anströmenden Arbeitsmedium die Turbinenwelle antreiben. Zur Führung des strömenden Arbeitsmediums in der Turbine sind zudem üblicherweise zwischen den benachbarten Laufschaufelreihen mit dem Turbinengehäuse verbundene Leitschaufelreihen angeordnet. Die Turbinenschaufeln weisen dabei ein zur geeigneten Führung des Arbeitsmediums vorteilhaft profiliertes und auf die Arbeitsmediumsparameter, wie Druck und Temperatur, ausgelegtes, entlang einer Schaufelachse sich erstreckendes Schaufelblatt auf. An das Schaufelblatt ist endseitig zur Befestigung der Turbinenschaufel am jeweiligen Trägerkörper, also Welle oder Gehäuse, eine sich quer zur Schaufelachse erstreckende, in zumindest einem Endbereich als Hakensockel ausgebildete Plattform angeformt.

Zur Erreichung eines besonders hohen Wirkungsgrads sind Gas- oder Dampfturbinen zum Antrieb von Generatoren aus thermodynamischen Gründen für besonders hohe Arbeitsmediumsparameter des in die Turbineneinheit einströmenden Arbeitsmediums ausgelegt. Bei Dampfturbinen können das durchaus Drücke oberhalb von 200 bar und Temperaturen oberhalb von 500 C sein.

Bei Gasturbinen können die Temperaturen des in die Turbineneinheit einströmenden Arbeitsmediums im Bereich von etwa 1200°C bis etwa 1300°C liegen.

Um auch bei sehr hohen Arbeitsmediumsparametern und entsprechend hohen thermischen Belastungen eine hohe Zuverlässigkeit und eine lange Lebensdauer einer Turbinenkomponente, insbesondere einer Schaufel, zu gewährleisten, sind besonders stark belastete Turbinenkomponenten kühlbar ausgebildet.

Des Weiteren sind drehende Turbinenkomponenten besonders hohen mechanischen Belastungen in radialer Richtung ausgesetzt. So sind Turbinenschaufeln in der Regel mit ihrer Achse in radialer Richtung ausgerichtet und müssen erheblichen Zugspannungen in dieser Richtung standhalten. Die mechanischen Belastungen sind um so gravierender, als in modernen Turbinen die Turbinenschaufeln üblicherweise als so genanntes Hohlprofil ausgebildet sind, um über die Beaufschlagung von Hohlräumen in thermisch besonders beanspruchten Bereichen eine Kühlung einer Turbinenschaufel im inneren Bereich zu gewährleisten.
Es hat sich als zweckmäßig erwiesen, eine Turbinenkomponente aus einem Material zu fertigen, das eine kristalline Vorzugsrichtung aufweist. Dazu kann die Turbinenkomponente als einkristalline Komponente ausgelegt sein. Das heißt, die kristalline Vorzugsrichtung ist durch die Einkristall-Struktur oder "Single-Crystal-Struktur" gegeben. Solch eine Komponente wird auch als "SX-Komponente" bezeichnet. Alternativ kann die kristalline Vorzugsrichtung aber auch gegeben sein, indem die Turbinenkomponente mit einer gerichtet erstarrten Struktur, d. h. als "Directional-Solidified-Struktur" ausgelegt ist. Solch eine Komponente wird auch als "DS-Komponente" bezeichnet. Aufgrund der kristallinen Vorzugsrichtung des Materials der Turbinenkomponente kann eine besonders gute, nämlich gerichtete und schnelle, Wärmeabfuhr und Zugspannungsbelastbarkeit entlang der kristallinen Vorzugsrichtung erreicht werden, die erheblich höher ist als bei einer Turbinenkomponente aus einem Material, das isotrop ist. Bei einer Turbinenschaufel ist die kristalline Vorzugsrichtung günstigerweise entlang der Schaufelachse angeordnet. Die Wärmeleitungseigenschaften und Zugspannungsbelastbarkeit einer solchen Turbinenschaufel sind entlang dieser kristallinen Vorzugsrichtung also besonders zweckmäßig für den Betrieb der Turbinenschaufel in einer Turbine. Ähnliche Maßnahmen lassen sich auch bei anderen Turbinenkomponenten in analoger Weise vorsehen.

Turbinenkomponenten, die erheblichen mechanischen und thermischen Belastungen ausgesetzt sind, insbesondere Turbinenschaufeln, sind üblicherweise als Ganzes oder teilweise, wie in der EP 0 815 993 A1 beschrieben, im Rahmen eines Gießvorgangs hergestellt, der es ermöglicht, der Turbinenkomponente als kristalline Vorzugsrichtung eine Directional-Solidified- und/oder Single-Crystal-Struktur aufzuprägen. So werden herkömmlicherweise SX- oder DS-Schaufeln in einem Arbeitsgang gegossen. Bedingt durch den Gießprozess sind Hinterschneidungen, wie sie vor allem bei den oben erläuterten Turbinenschaufeln mit einer Ankerplattform oder Hohlräumen vorkommen, nicht oder nur schwer realisierbar. Jedenfalls führen komplexe Geometrien in der Regel zu hohen Ausschussraten, was die Wirtschaftlichkeit des Gießvorgangs, der eine solche Turbinenkomponente als Ganzes hervorbringen muss, herabsetzt. Bisher werden solche hohen Ausschussraten in Kauf genommen. Ein Versuch, Ausschussraten bei einer Turbinenkomponente mit einer kristallinen Vorzugsrichtung, insbesondere bei einer SX- und/oder DS-Turbinenkomponente, zu senken, besteht darin, eine solche Turbinenkomponente "gießgerecht", d. h., in der Regel einfacher strukturiert als ursprünglich gewünscht zu konstruieren. Dies ist oft zum Nachteil der Gebrauchseigenschaften einer solchen Turbinenkomponente.

Zusammenfassend ist also festzuhalten, dass Turbinenkomponenten, insbesondere rotierende Komponenten, die hohen thermischen und mechanischen Belastungen ausgesetzt sind und gleichzeitig eine für einen Gießvorgang komplexe Bauweise aufweisen, im Gießprozess nur schwer mit einer kristallinen Vorzugsrichtung herzustellen sind. Entweder müssen hohe Ausschussraten in Kauf genommen werden oder aber es muss eine unnötig, lediglich für den Gießvorgang vereinfachte Konstruktion einer Turbinenkomponente akzeptiert werden. Diese Probleme sind um so gravierender, als bisher eine einkristalline oder gerichtet verfestigte Turbinenkomponente als Ganzes im Rahmen eines Gießvorgangs gegossen werden muss.

Hier setzt die Erfindung an, deren Aufgabe es ist, ein Verfahren gemäß Anspruch 1 und eine Vorrichtung gemäß Anspruch 15 zur Herstellung einer Turbinenkomponente, eine Verwendung der Vorrichtung gemäß Anspruch 19 und eine Turbinenkomponente gemäß Anspruch 20 anzugeben, so dass die Turbinenkomponente trotz gegebenenfalls komplexer Bauweise auf besonders einfache Weise und mit möglichst geringer Ausschussrate hergestellt werden kann.

Betreffend das Verfahren zur Herstellung der Turbinenkomponente wird die Aufgabe durch das Verfahren gemäß Anspruch 1 gelöst.

Betreffend die Vorrichtung wird die Aufgabe durch die Vorrichtung gemäß Anspruch 15 gelöst.

Die Erfindung geht dabei von der Überlegung aus, dass die Turbinenschaufel für eine besonders gut, insbesondere thermisch und mechanisch zweckmäßige, Funktionsweise in einkristalliner Bauweise ausgestaltet sein sollte, dazu jedoch nicht notwendigerweise als Ganzes im Rahmen eines einzigen Gießvorgangs hergestellt sein muss. Die Erfindung sieht statt dessen vor, eine Turbinenkomponente im Wesentlichen aus einem Basisteil und einem Aufbaumaterial zusammenzufügen. Wesentlich ist, dass gemäß dem Konzept der Erfindung gewährleistet ist, dass mindestens der Teilbereich der Turbinenkomponente, welcher als Fügebereich zwischen dem Basisteil und dem Aufbaumaterial der Turbinenkomponente angeordnet ist, eine kristalline Vorzugsrichtung aufweist. Der Erfindung liegt dabei die Erkenntnis zugrunde, dass mittels eines Keimbildners beim Überführen dem Aufbaumaterial mindestens in dem Teilbereich der Fügezone eine kristalline Vorzugsrichtung initiiert wird, so dass bisher in Kauf genommene thermisch und mechanisch nachteilige Eigenschaften einer Fügezone ohne kristalline so dass bisher in Kauf genommene thermisch und mechanisch nachteilige Eigenschaften einer Fügezone ohne kristalline Vorzugsrichtung vermieden werden. Das eine Basisteil oder weitere Basishilfsteile einer der Turbinenkomponente könnten zur Fertigstellung der Turbinenkomponente wieder entfernt werden. Zur Herstellung einer gänzlich mit einer kristallinen Vorzugsrichtung versehenen Turbinenkomponente weist das Aufbaumaterial der Turbinenkomponente auch über den Teilbereich hinaus eine kristalline Vorzugsrichtung auf.

Durch die Verwendung des separaten Keimbildners ist dabei auch die nachträgliche Aufwertung oder Weiternutzung eines eigentlich nicht einkristallinen Ausgangsteils oder eines Ausgangsteils mit gestörter Kristallstruktur möglich. Das vorgeschlagene Konzept der Erfindung ermöglicht erstmalig eine besonders wirtschaftliche Herstellung auch komplexer Turbinenkomponenten mit einer kristallinen Vorzugsrichtung, da auch der Teilbereich die kristalline Vorzugsrichtung aufweist. Ein einfacher Zusammenbau von Teilen mit jeweils einer kristallinen Vorzugsrichtung würde nachteilig sein, da bei herkömmlichen Fügeverfahren der Teilbereich einer Fügezone keine kristalline Vorzugsrichtung aufweist und deshalb nicht die oben erwähnten vorteilhaften thermischen und mechanischen Eigenschaften für eine Turbinenkomponente mit sich bringen würde. Dagegen ermöglicht das Konzept der Erfindung auch den Zusammenbau, das Zusammenfügen oder das Zusammengießen völlig mit einer kristallinen Vorzugsrichtung versehener Turbinenkomponenten, wobei auch der Teilbereich der Fügezone die kristalline Vorzugsrichtung aufweist. Die Erfindung nutzt dabei das physikalische Prinzip der Keimbildung beim Wechsel eines Aggregatzustandes. Das Aufbaumaterial im Teilbereich wird also von einem ersten Zustand in einen festen zweiten Zustand überführt und ein Keimbildner initiiert eine kristalline Vorzugsrichtung, die sich beim Überführen so im Aufbaumaterial des Teilbereichs fortsetzt, dass nach dem Überführen mindestens der Teilbereich die kristalline Vorzugsrichtung aufweist. Das heißt, der Teilbereich weist keine isotrope Struktur auf, sondern insbesondere genau diejenigen kristalline Vorzugsrichtung, welche auch die weiteren Teile der Turbinenkomponente aufweisen.

Das Aufbaumaterial kann dabei insbesondere als Schmelze und somit in flüssigem Zustand als erstem Zustand zugeführt werden. Das Gießen einer Turbinenkomponente mit einer komplexen Geometrie wird auf besonders einfache Weise und dennoch mit sehr geringer Ausschussrate ermöglicht, denn die Turbinenkomponente muss gemäß dem Konzept der Erfindung nicht als Ganzes gefertigt werden, sondern kann aus einzelnen Gussteilen zusammengefügt werden. Der eigentliche Gießvorgang beschränkt sich also jeweils nur auf einen Teil einer Turbinenkomponente. Die Ausschussrate bei einem Teil der Turbinenkomponente ist natürlicherweise geringer, da das Teil, z. B. ein Basisteil oder ein Aufbauteil des Aufbaumaterials, kleinere Abmessungen als die Turbinenkomponente aufweist und zudem so gewählt werden kann, dass dieses günstig zu gießen ist. Auf diese Weise kann selbst eine komplexe Turbinenkomponente aus einfach zu gießenden Teilen zusammengefügt werden.

Vorteilhafte Weiterbildungen der Erfindung hinsichtlich des Verfahrens und der Vorrichtung sind den Verfahrens- und Vorrichtungsunteransprüchen zu entnehmen und geben im Einzelnen vorteilhafte Möglichkeiten an, eine besonders günstige Turbinenkomponente herzustellen.

Das Verfahren lässt sich besonders einfach durchführen, wenn das Basisteil bereits so ausgebildet ist, dass es als Keimbildner für die kristalline Vorzugsrichtung wirkt. Dabei kann beispielsweise die an den Teilbereich grenzende Oberfläche des Basisteils als Keimbildner für die kristalline Vorzugsrichtung wirken. Vorteilhaft weist der Teilbereich als kristalline Vorzugsrichtung dabei eine Directional-Solidified- und/oder Single-Crystal-Struktur auf. Dies sind die zwei besonders bevorzugten Strukturen, welche bei einem Gießvorgang eines Teils der Turbinenkomponente verwirklicht werden. Infolge der Wirkung des Keimbildners setzt sich auch im Teilbereich eine Directional-Solidified- und/oder Single-Crystal-Struktur bei der Überführung von dem ersten in den zweiten festen Zustand durch.

Gemäß einer ersten Variante des Verfahrens kann dieses zur kompletten Neufertigung einer Turbinenkomponente genutzt werden. Insbesondere für diese erste Variante erweist es sich als besonders zweckmäßig, dass das Aufbaumaterial als ein Aufbauteil an das Basisteil gesetzt wird und der Teilbereich das Basisteil und das Aufbauteil verbindende Fügezone bildet. Dabei kann es auch zweckmäßig sein, dass das Aufbaumaterial ein zwischen dem Aufbauteil und dem Basisteil angeordnetes und das Zusammenfügen des Aufbauteils und des Basisteils unterstützenden Zusatzmaterial umfasst. Das Zusatzmaterial ist zweckmäßigerweise auf den Fügeprozess angepasst. Besonders vorteilhaft wird das Aufbauteil in vertikaler Richtung auf das Aufbaumaterial aufgesetzt. Es hat sich gezeigt, dass der Keimbildner bei dieser Ausrichtung besonders vorteilhaft die kristalline Vorzugsrichtung initiiert.

Insbesondere zur Herstellung einer gänzlich mit einer kristallinen Vorzugsrichtung versehenen Turbinenkomponente ist es zweckmäßig, dass das Basisteil und das Aufbauteil mindestens in dem an den Teilbereich grenzenden Bereich als kristalline Vorzugsrichtung eine Directional-Solidified- und/oder Single-Crystal-Struktur aufweist. Vorteilhaft sind das Basisteil und das Aufbauteil gänzlich mit einer kristallinen Vorzugsrichtung versehen. Das Basisteil muss nicht notwendigerweise eine kristalline Vorzugsrichtung aufweisen, denn es könnte auch jede andere geeignete Art von Keimbildner bereitstellen und das Basisteil könnte dann zur Fertigstellung der Turbinenkomponente wieder abgetragen werden. In diesem Fall würde nur das Aufbauteil mindestens in dem an den Teilbereich grenzenden Bereich als kristalline Vorzugsrichtung eine Directional-Solidified- und/oder Single-Crystal-Struktur aufweisen.

Gemäß einer weiteren Variante des vorgeschlagenen Konzepts kann das Verfahren zur Herstellung der Turbinenkomponente auch angewendet werden, um im Bereich des "Refurbishment" eine Turbinenkomponente zu reparieren oder anderweitig vorteilhaft zu behandeln, beispielsweise zu beschichten. Insbesondere bei dieser Variante würde das Basisteil bereits eine entweder zu beschichtende oder zu reparierende Turbinenkomponente sein, die mindestens in dem an den Teilbereich grenzenden Bereich als kristalline Vorzugsrichtung eine Directional-Solidified- und/oder Single-Crystal-Struktur aufweist. Bei dieser zweiten Variante des vorgeschlagenen Konzepts würde jedenfalls nicht immer ein Aufbauteil auf das Basisteil aufgesetzt, sondern in der Regel eine oder mehrere Schichten als Teilbereiche auf das Basisteil aufgebracht werden. Entsprechend kann das Aufbaumaterial als eine oder mehrere Schichten von Zusatzmaterial auf das Basisteil aufgebracht werden, wobei der Teilbereich die eine oder mehrere Schichten Zusatzmaterial und eine das Basisteil verbindende Fügezone umfasst. Bei der hier erläuterten zweiten Variante des vorgeschlagenen Konzepts könnten eine Anzahl von Schichten zur Reparatur oder anderweitigen Behandlung einer Turbinenkomponente, beispielsweise zur Beschichtung derselben, aufgebracht werden, wobei sich die kristalline Vorzugsrichtung von einer ersten Schicht auf eine zweite benachbarte Schicht aufgrund der Keimbildung fortpflanzt.

Beide Varianten des bislang erläuterten Konzepts können selbstverständlich wiederholt hintereinander, einzeln oder in Kombination durchgeführt werden. Gemäß der ersten Variante des vorgeschlagenen Konzepts können also mehrere Aufbauteile jeweils durch einen zwischen benachbarte Aufbau-/Basisteile als Fügezone ausgebildeten Teilbereich zusammengefügt werden, wobei mindestens der Teilbereich die kristalline Vorzugsrichtung aufweist. Nicht alle Aufbau-/Basisteile müssen notwendigerweise eine kristalline Vorzugsrichtung aufweisen. Zur Herstellung einer gänzlich mit einer kristallinen Vorzugsrichtung versehenen Turbinenkomponente weisen jedoch alle Teile und Teilbereiche die gleiche kristalline Vorzugsrichtung auf. Prinzipiell ist es auch möglich, bei einer Turbinenkomponente eine erste und eine zweite und gegebenenfalls auch weitere voneinander abweichende kristalline Vorzugsrichtungen derart vorzusehen, dass diese für die thermische und mechanische Belastung der Turbinenkomponente günstig ausgerichtet sind. Entsprechend könnten dazu Basisteile mit unterschiedlichen kristallinen Vorzugsrichtungen als Keimbildner vorgesehen werden, die aufgrund der Keimbildung in einem Teilbereich und gegebenenfalls einem Aufbauteil die kristalline Vorzugsrichtung initiieren.

Auch eine Kombination der hier erläuterten ersten Variante und zweiten Variante des vorgeschlagenen Konzepts kann durchgeführt werden. Dies erweist sich insbesondere im Falle einer Reparatur einer Turbinenkomponente als vorteilhaft, wenn beispielsweise zum Teil Beschichtungen bei einer zu reparierenden Turbinenkomponente vorgenommen werden müssen - gemäß der zweiten Variante - oder eine neues Teil an die Turbinenkomponente angesetzt werden muss - gemäß der ersten Variante.

Prinzipiell kann der erste Zustand ein beliebiger fester Zustand oder auch ein flüssiger oder gasförmiger Zustand sein. Insbesondere wenn das Überführen von einem gasförmigen oder einem flüssigen Zustand in einen festen zweiten Zustand erfolgt, erweist es sich als günstig, dass das Überführen durch Kühlen mindestens des Teilbereichs beschleunigt wird. Auch können weitere Verfahrensparameter z. B. hinsichtlich Temperatur und Druck zum Überführen eingestellt werden. Dabei wird in besonders vorteilhafter Weiterbildung ein Temperaturgradient in Richtung der einzustellenden Vorzugsorientierung eingestellt, so dass die Ausbildung der kristallinen Vorzugsrichtung bereits durch das lokale Wärmeangebot noch begünstigt wird.

Weiterbildungen des Verfahrens sehen vor, dass das Überführen und Aufbringen des Aufbaumaterials in unterschiedlicher Weise erfolgt.

So erweist es sich als günstig, dass das Aufbaumaterial im Rahmen eines Schweißvorgangs und/oder eines Umschmelzvorgangs als Zusatzmaterial aufgebracht wird, wobei der erste Zustand des Zusatzmaterials ein flüssiger Zustand ist. Als Schweißvorgang ist dabei vorzugsweise ein Auftragsschweißvorgang vorgesehen; es könnte sich aber auch um einen Umschmelzvorgang handeln. Diese Vorgänge sind gleichermaßen vorteilhaft zum Anbringen weiterer Teile gemäß der ersten Variante oder lediglich zum Auftragen weiterer, vorzugsweise geschichteter Teilbereiche. Als besonders zweckmäßig erweist sich das Laserschweißen, insbesondere das Laser-Pulver-Auftragsschweißen. Ein Teilbereich ist dabei günstigerweise als eine ausgeweitete Schweißlage gebildet, welche in ihrer Ausdehnung über die Ausdehnung einer üblichen Schweißlage hinausgeht.

Beim üblichen Schweißverfahren wird als Aufbaumaterial zweckmäßigerweise Schweißzusatzmaterial als auch Aufbaumaterial aufgebracht. Infolge des Schweißvorgangs wird mindestens der Teilbereich mit dem Zusatzmaterial und vorteilhaft auch Grenzbereiche des Basisteils aufgeschmolzen und in dem Teilbereich durch einen Keimbildner eine kristalline Vorzugsrichtung initiiert. Auf diese Weise weisen sowohl der Teilbereich als auch die Grenzbereiche des Basisteils und des Aufbauteils die kristalline Vorzugsrichtung auf. Beim Umschmelzen oder Laserschweißen kann ein Zusatzmaterial gegebenenfalls entfallen, so dass lediglich Basisteil und Aufbauteil aufeinander gesetzt werden. In diesem Fall ist das Aufbauteil bereits als Aufbaumaterial zu verstehen. Beim Umschmelzen werden dann die aneinander liegenden Grenzbereiche des Basisteils und des Aufbauteils aufgeschmolzen, eine kristalline Vorzugsrichtung wird beim Überführen vom flüssigen in den festen Zustand initiiert, so dass nach dem Überführen mindestens der Teilbereich der Fügezone die kristalline Vorzugsrichtung aufweist.

Insbesondere zum Aufbringen geschichteter Teilbereiche erweist es sich als günstig, dass das Aufbaumaterial, insbesondere Zusatzmaterial, durch Laser-Pulver-Auftragsschweißen aufgebracht wird. Bei dieser Methode wird das Aufbaumaterial als Pulver in einen Laserstrahl eingeblasen, schmilzt dort und gelangt anschließend flüssig auf das Basisteil.

Alternativ könnte Aufbaumaterial, insbesondere Zusatzmaterial, im Rahmen eines Spritz-Pinsel- oder auch Tauchvorgangs aufgebracht werden, wobei der erste Zustand ein flüssiger Zustand ist. Die Art und Weise, wie Aufbaumaterial aufgebracht und vom ersten Zustand in den zweiten Zustand überführt wird, lässt sich vorteilhaft für die herzustellende Turbinenkomponente und je nach Wahl des Aufbaumaterials vorteilhaft auswählen. Eine weitere günstige Möglichkeit besteht darin, das Aufbaumaterial, insbesondere Zusatzmaterial, als Folie, Blech oder Draht aufzubringen, wobei der erste Zustand ein flüssiger Zustand ist.

Alle bisher erläuterten Weiterbildungen des vorgeschlagenen Konzepts lassen sich im Rahmen eines Schweiß- oder Umschmelzvorgangs realisieren. Dabei erweist es sich als besonders vorteilhaft, das Basisteil als Schweißbadsicherung zu verwenden. Die Aufbringvorrichtung zum Aufbringen von Aufbaumaterial kann eine Vorrichtung aus der Gruppe bestehend aus Schweißvorrichtung, Umschmelzvorrichtung und Auftragvorrichtung sein.

Gemäß einer ganz besonders bevorzugten Weiterbildung der Erfindung ist vorgesehen, dass das Aufbaumaterial und das Aufbauteil schichtweise aufgebracht werden, wobei der erste Zustand ein flüssiger Zustand ist, und wobei schrittweise Schichten einer Dicke von jeweils etwa 0,25 bis 0,5 mm aufgebracht werden. Zur Realisierung dieser besonders bevorzugten Weiterbildung des Verfahrens könnte ein einzelnes oder mehrere Basisteile bereitgestellt werden, auf die der weitere Körper der Turbinenkomponente schichtweise aufgegossen wird. Beim Überführen der ausgegossenen Masse vom flüssigen in den festen Zustand wirkt das Basisteil als Keimbildner und initiiert eine kristalline Vorzugsrichtung im Aufbaumaterial derart, dass nach dem Überführen der Masse vom flüssigen in den festen Zustand mindestens der Teilbereich, vorzugsweise die gesamte Masse, die kristalline Vorzugsrichtung des Basisteils aufweist. Dieser Vorgang kann mehrmals wiederholt werden. Auch kann ein besonders günstiges Basisteil als Keimbildner vorgesehen werden. Es könnte auch ein solches Basisteil wieder entfernt werden. Die genannten Möglichkeiten erlauben, durch einen oder mehrere Aufbringvorgänge selbst komplexe Strukturen einer Turbinenkomponente mit niedriger Ausschussrate herzustellen.

Die Verfahrensparameter zum Überführen der Masse in den festen Zustand können dabei für die Überführung zweckmäßig gewählt werden. Insbesondere ist bei der Vorrichtung eine Kühlung vorgesehen.

Betreffend die Verwendung wird die Aufgabe durch Anspruch 19 gelöst. Eine Neufertigung einer Turbinenkomponente kann dabei entweder durch das Zusammenfügen mehrerer Teile oder durch das Hintereinanderausführen wenigstens eines Gießvorgangs erfolgen. Auf ähnliche Weise könnte auch die Reparatur einer Turbinenkomponente erfolgen. Die vorgeschlagene Vorrichtung kann auch zur Beschichtung neu gefertigter oder zu reparierender Turbinenkomponenten verwendet werden. Dazu könnten beispielsweise mehrere Teilbereiche schichtweise auf einen vorhandenen Körper einer Turbinenkomponente aufgebracht werden. Dies kann in der oben erläuterte Weise durch Schweißen, Umschmelzen oder epitaktische Verfahren erfolgen. Zur Herstellung einer Turbinenkomponente können eines oder mehrere der vorgeschlagenen Aufbring- und Überführungsverfahren miteinander kombiniert werden. So ist bei spielsweise bereits erläutert worden, dass ein oder mehrere Gießteile als Aufbauteile mittels eines Schweißvorgangs zusammengefügt werden können, so dass eine gänzlich mit einer kristallinen Vorzugsrichtung versehene Turbinenkomponente entsteht. Auch könnte eine Turbinenkomponente im Wesentlichen durch mehrere hintereinander ausgeführte Gießvorgänge hergestellt werden, wobei eine durch ein Basisteil vorgegebene kristalline Vorzugsrichtung bei jedem Gießvorgang der Gießmasse initiiert wird und sich schließlich auf die gesamte Turbinenkomponente gänzlich erstreckt. Anschließend könnten weitere Teilbereiche mit der gleichen oder, wenn gewünscht, auch mit einer anderen kristallinen Vorzugsrichtung schichtweise auf der Turbinenkomponente aufgebracht werden. Dies könnte epitaktisch oder durch einen Schweißvorgang erfolgen.

Betreffend die Turbinenkomponente wird die Aufgabe durch Anspruch 20 gelöst. Des Weiteren wird die Aufgabe gemäß der Erfindung durch eine Turbinenkomponente mit mindestens einem Teilbereich gelöst, wobei der Teilbereich Aufbaumaterial aufweist, das von einem ersten Zustand in einen festen zweiten Zustand unter Initiierung einer kristallinen Vorzugsrichtung durch einen Keimbildner überführt ist, so dass nach dem Überführen mindestens der Teilbereich die kristalline Vorzugsrichtung aufweist. Vorzugsweise grenzt der Teilbereich an ein Aufbauteil, das mindestens in einem an den Teilbereich grenzenden Bereich die kristalline Vorzugsrichtung aufweist.

Gemäß einer Weiterbildung der Turbinenkomponente erweist es sich ebenfalls als günstig, dass der Teilbereich an einen Basisteil grenzt, das mindestens in einem an den Teilbereich grenzenden Bereich die kristalline Vorzugsrichtung aufweist. In diesem Fall wäre das Basisteil auch ein Teil der fertiggestellten Turbinenkomponente.

Vorteilhaft weist der Teilbereich und/oder das Basisteil und/oder das Aufbaumaterial als kristalline Vorzugsrichtung eine Directional-Solidified- und/oder Single-Crystal-Struktur auf. Insbesondere zur Herstellung einer Turbinenkomponente, die im Wesentlichen gänzlich eine kristalline Vorzugsrichtung aufweist, erweist es sich als günstig, dass diese aus mehreren Teilen aufgebaut ist, welche jeweils gänzlich eine kristalline Vorzugsrichtung aufweisen.

Eine vorgenannte Turbinenkomponente ist günstigerweise als Turbinenschaufel ausgebildet, denn bei einer Turbinenschaufel erweist sich das Konzept gemäß der Erfindung als besonders vorteilhaft. Insbesondere eine Laufschaufel hat, wie eingangs erläutert, als rotierende Turbinenkomponente in hohem Maße und entlang ihrer axialen Ausdehnung wirkende thermische und mechanische Belastungen zu tragen. Ein einkristalliner Aufbau oder eine in Richtung der axialen Ausdehnung gerichtete Verfestigung der Turbinenschaufel, infolge eines spezifisch initiierten kristallinen Aufbaus mit Vorzugsrichtung erweist sich als besonders vorteilhaft. Eine solche Turbinenschaufel lässt sich damit selbst in komplexer Bauweise und mit niedriger Ausschussrate herstellen.

Ausführungsbeispiele der Erfindung werden nun nachfolgend anhand der Zeichnung beschrieben. Diese soll die Ausführungsbeispiele nicht maßstäblich darstellen, vielmehr ist die Zeichnung, wo zur Erläuterung dienlich, in schematisierter und/oder leicht verzerrter Form ausgeführt. Im Hinblick auf Ergänzungen der aus der Zeichnung unmittelbar erkennbaren Lehren wird auf den einschlägigen Stand der Technik verwiesen. Dabei ist zu berücksichtigen, dass vielfältige Modifikationen und Änderungen betreffend Form und Detail einer Ausführungsform vorgenommen werden können, ohne von der allgemeinen Idee der Erfindung abzuweichen. Die in der vorstehenden Beschreibung, in der Zeichnung sowie in den Ansprüchen offenbarten Merkmale der Erfindung können sowohl einzeln als auch in beliebiger Kombination für die Ausgestaltung der Erfindung wesentlich sein. Die allgemeine Idee der Erfindung ist nicht beschränkt auf die exakte Form oder das Detail der im Folgenden gezeigten und beschriebenen bevorzugten Ausführungsform oder beschränkt auf einen Gegenstand, der eingeschränkt wäre im Vergleich zu dem in den Ansprüchen beanspruchten Gegenstand.

Als Ausführungsformen der Erfindung werden verschiedene Verfahren der Herstellung und zum Zusammenfügen einer DS-/SX-Turbinenschaufel beschrieben. Im Einzelnen zeigen die Figuren der Zeichnung in:
FIG 1 eine bevorzugte Möglichkeit der Erzeugung einer überhängenden Geometrie bei einer Turbinenkomponente, die auf herkömmliche Weise gusstechnisch nicht bzw. nur schlecht hergestellt werden kann, jedoch gemäß dem vorgeschlagenen Konzept besonders einfach und mit geringem Ausschuss hergestellt werden kann;
FIG 2 eine weitere bevorzugte Möglichkeit der Erzeugung einer überhängenden Geometrie bei einer Turbinenkomponente ähnlich wie in FIG 1, bei der jedoch ein Basisteil zur Fertigstellung der bevorzugten Turbinenschaufel wieder entfernt wird;
FIG 3 eine bevorzugte Möglichkeit zur Beschichtung einer Turbinenkomponente, die sowohl im Rahmen einer Neufertigung als auch bei einer Reparatur gemäß dem vorgeschlagenen Konzept angewendet werden kann.

Im Folgenden wird anhand zweier Figuren beispielhaft erläutert, wie die Herstellung von DS-/SX-Schaufeln z. B. aus vorgeformten Komponenten vorteilhaft erfolgt. Gemäß der besonders bevorzugten Ausführungsform kann eine Montage einer DS-/SX-Schaufel sowohl zur Neufertigung als auch zur Reparatur von DS- oder SX-Teilen erfolgen. Die vorgeformten Komponenten können dabei gemäß einer ersten Abwandlung mittels epitaktischem Aufwachsen von DS-/SX-Schichten verbunden werden. Die DS-/SX-Schicht bildet dabei einen als Fügezone ausgebildeten Teilbereich, welcher ebenso wie die vorgeformten DS-/SX-Komponenten eine DS-/SX-Struktur, also eine kristalline Vorzugsrichtung aufweist.

Gemäß einer zweiten Abwandlung kann die Herstellung der Komponenten mit kristalliner Vorzugsrichtung mittels DS-/SX-Auftragsschweißen, insbesondere schichtweisem Auftragsschweißen, oder Umschmelzen erfolgen. Dabei kann insbesondere eine spezielle Form einer Schweißbadsicherung vorteilhaft angewendet werden. Zum Beispiel eignet sich die Verwendung einer Schweißbadsicherung, die als Basisteil für die Vergabe einer Kristallisationsrichtung vorgesehen ist. Die Schweißbadsicherung wird somit als Keimbildner für die aufzubringenden Materialien verwendet.

Gemäß noch einer weiteren Abwandlung erfolgt das Zusammenfügen vorgeformter DS-/SX-Komponenten zur Herstellung einer DS-/SX-Schaufel mittels Laserschweißens oder eines laserinduzierten Umschmelzens, insbesondere schichtweise. Dabei kann die Werkstoffzuführung auf unterschiedliche Art und Weise erfolgen. Zum Beispiel kann ein zweites Zusatzmaterial als Aufbaumaterial aufgespritzt, ein Aufbauteil aufgesetzt und die Fügezone anschließend laserinduziert umgeschmolzen werden. Aufbaumaterial kann ebenso als Pulver mit und ohne Binder aufgetragen werden. Außerdem gibt es verschiedene Möglichkeiten einer Schlickerbeschichtung, beispielsweise durch Aufpinseln, Tauchen oder Aufspritzen. Auch dabei erfolgt der Umschmelz- oder Schweißvorgang vorteilhaft mittels eines Lasers. Eine weitere Möglichkeit des Aufbringens von Aufbaumaterial besteht darin, das Aufbaumaterial als Folie, Blech oder Draht aufzulegen und, gegebenenfalls nach Aufsetzen eines Aufbauteils mittels Laserpunktschweißens, von einem ersten flüssigen Zustand in einen zweiten festen Zustand zu überführen. Dies hat den Vorteil, dass nicht das gesamte Aufbaumaterial aufgeschmolzen werden muss. Wenn erwünscht, kann jedoch auch ein Umschmelzvorgang vorgenommen werden.

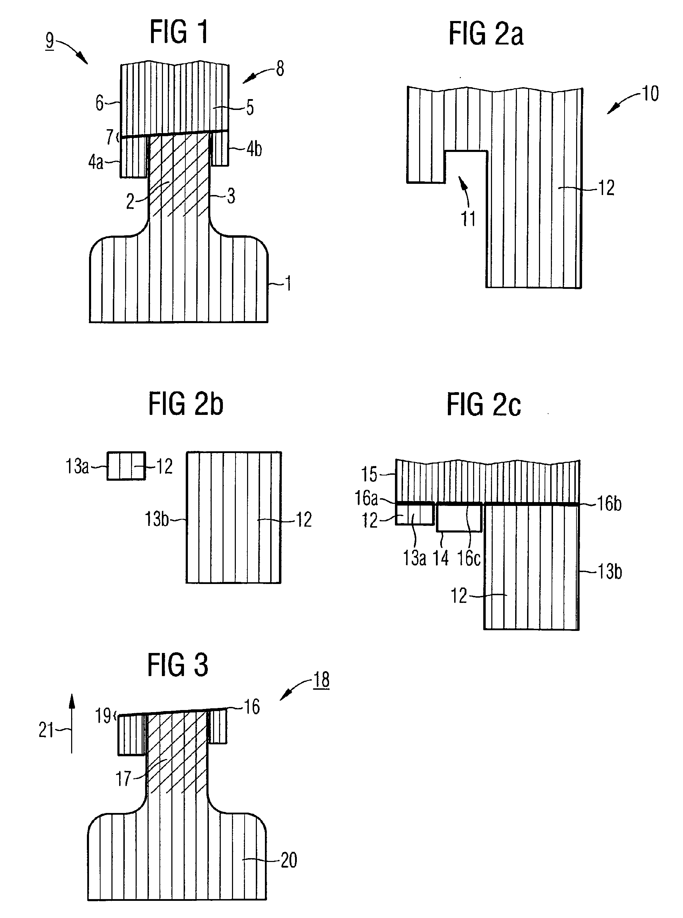

Die oben genannten Abwandlungen eignen sich allesamt zur Erzeugung überhängender Geometrien, die gusstechnisch nicht oder nur schlecht hergestellt werden können. Ein Beispiel solch einer Geometrie ist in der FIG 1 gezeigt. Zur Herstellung einer Turbinenschaufel im Verankerungsbereich wird dazu ein Turbinenschaufelteil oder eine Turbinenkomponente 9 an ihrem verankerungsseitigen Ende als Basisteil 1 bereitgestellt. Dieses ist als ein SX-Gussteil im Rahmen eines Gießprozesses erstellt worden und weist somit eine durch die parallele Strichanordnung symbolisch dargestellte kristalline Vorzugsrichtung 2 auf. Die Turbinenkomponente 9 ist an ihrem verankerungsseitigen Ende tailliert. Zur Anbringung der Verankerung ist dazu ein weiteres erstes Basishilfsteil 4a und ein zweites Basishilfsteil 4b seitlich der Taille 3 angeordnet. Auch diese Basishilfsteile 4a, 4b sind mit einer SX-Struktur versehen, welche der kristallinen Vorzugsrichtung 2 des Basisteils 1 entspricht. Die Basishilfsteile 4a und 4b sind dabei als eine Schweißbadsicherung bei einem Schweißbad ausgebildet.

Auf das Basisteil 1 und die Basishilfsteile 4a und 4b kann mittels einer der oben beschriebenen Abwandlungen Zusatzmaterial 5 aufgebracht werden. Anschließend wird ein ebenfalls mit einer SX-/DS-Struktur als kristalline Vorzugsrichtung versehenes Aufbauteil 6 in vertikaler Richtung aufgebracht. Das Zusatzmaterial 5 und das Aufbauteil 6 bilden bei dieser Ausführungsform das Aufbaumaterial 8. Bei der in FIG 1 gezeigten bevorzugten Ausführungsform des Herstellungsverfahrens werden dann sowohl das Zusatzmaterial 5 als auch Materialien des Aufbauteils 6 und der Basisteile 1, 4a und 4b in einem an das Zusatzmaterial 5 grenzenden Teilbereich 7, d. h. in einem an das Basisteil 1 und an das Aufbauteil 6 grenzenden Teilbereich 7, verflüssigt und dann von diesem ersten flüssigen Zustand in einen festen zweiten Zustand überführt.

Das Aufbauteil 6 wird dabei insbesondere schichtweise aufgebracht, wobei in aufeinander folgenden Depositionsschritten Schichten einer Dicke von beispielsweise etwa 0,25 bis 0,5 mm aufgebracht werden. Beim Überführen wirken die an den Teilbereich 7 grenzenden Oberflächen des Basisteils 1 und der Basishilfsteile 4a und 4b als Keimbildner, so dass beim Überführen dem Zusatzmaterial 5 und dem an das Zusatzmaterial 5 grenzenden aufgeschmolzenen Teilbereichen 7 des Aufbauteils 6 eine kristalline Vorzugsrichtung als SX-Struktur initiiert wird. Nach dem Überführen weist also der gesamte als Fügebereich wirkende Teilbereich 7, der mindestens den Bereich des Zusatzmaterials 5 umfasst, die kristalline Vorzugsrichtung als SX-Struktur auf. Das heißt, die aus den Teilen 1, 4a, 4b, 5 und 6 bestehende Turbinenschaufel weist eine gänzlich durchgehende SX-Struktur auf, die sich gemäß dieser bevorstehenden Ausführungsform vor allem auch im Teilbereich 7 des Zusatzmaterials 5 und den daran angrenzenden Bereichen des Aufbauteils 6 und des Basisteils 1 und der Basishilfsteile 4a, 4b fortsetzt.

Bei der hier beschriebenen bevorzugten Ausführungsform des Herstellungsverfahrens werden das Basishilfsteil 4a und das Basishilfsteil 4b nach dem Fügevorgang wieder entfernt. In diesem Fall erweist sich ein spanendes Entfernen, beispielsweise durch Abdrehen oder Fräsen, als besonders vorteilhaft.

In der FIG 2a ist eine weitere gewünschte Ausführungsform einer Turbinenkomponente 10, im Ausführungsbeispiel eine Turbinenschaufel, gezeigt, welche im unteren Bereich 11 eine überhängende Geometrie aufweist und somit gusstechnisch nicht oder nur schlecht hergestellt werden kann. Mittels der in den FIG 2b und FIG 2c weiter verdeutlichten Herstellungsschritten kann dennoch eine solche Turbinenkomponente 10 besonders einfach, mit geringem Ausschuss und durchgängig kristalliner Vorzugsrichtung 12 hergestellt werden.

Ähnlich wie bereits anhand der FIG 1 erläutert, wird dazu gemäß FIG 2b in einem ersten Herstellungsschritt ein erstes Basisteil 13a und ein zweites Basisteil 13b bereitgestellt. Beide Basisteile 13a und 13b weisen ebenfalls die kristalline Vorzugsrichtung 12 auf. In einem weiteren in FIG 2c dargestellten Schritt wird neben den Basisteilen 13a und 13b auch ein Basishilfsteil 14 bereitgestellt. Dieses muss nicht notwendigerweise eine SX-Struktur aufweisen. Bei der vorliegenden Ausführungsform ist es aus einem Kompositwerkstoff hergestellt, der sich einerseits als Keimbildner eignet, des Weiteren aber auch nach dem Herstellungsprozess der in FIG 2c gezeigten Struktur wieder entfernt werden kann, um die in FIG 2a gezeigte Turbinenkomponente 10 fertigzustellen.
Nachdem die Basisteile 13a, 13b und das Basishilfsteil 14 bereitgestellt sind, kann gemäß FIG 2c ein Aufbauteil 15 in vertikaler Richtung auf die Basisteile 13a, 13b und auf das Basishilfsteil 14 aufgesetzt werden. Zusatzmaterial wie in FIG 1 ist in diesem Falle nicht vorgesehen. Das Aufbauteil 15 bildet das Aufbaumaterial. Mittels eines Fügevorgangs, beispielsweise eines Schweißvorgangs, wird in einem Teilbereich 16a und 16b Material im Grenzbereich zwischen dem Aufbauteil 15 und den Basisteilen 13a und 13b aufgeschmolzen. Ebenso wird Material des Aufbauteils 15 in einem Teilbereich 16c als Grenzbereich zwischen Aufbauteil 15 und Basishilfsteil 14 sowie Material des Kompositwerkstoffs des Basishilfsteils 14 aufgeschmolzen und anschließend von diesem ersten flüssigen Zustand in einen festen zweiten Zustand überführt. Sowohl der Kompositwerkstoff des Basishilfsteils 14 als auch die SX-Struktur des Basisteils 13a, 13b wirkt dabei als Keimbildner und initiiert in den Teilbereichen 16a, 16b und 16c eine kristalline Vorzugsrichtung 12, so dass nach dem Überführen die Teilbereiche 16a, 16b und 16c als auch das Aufbauteil 15 und auch die die kristalline Vorzugsrichtung 12 aufweisen.

Anschließend wird das Basishilfsteil 14 entfernt, was bei dem verwendeten Kompositwerkstoff durch verschiedenste Methoden besonders leicht erfolgen kann. Auf diese Weise wird die Turbinenkomponente 10 als durchgängig mit einer kristallinen Vorzugsrichtung 12 versehenes Turbinenteil, wie in FIG 2a dargestellt, mit überhängender Geometrie 11 fertiggestellt.

Wenn das Basishilfsteil 14 als Keimbildner wirkt (SX/DS-Struktur) und L-förmig aufgebildet ist und der L-Fuss an dem zweiten Basisteil 13b befestigt ist, kann auch mittels Auftragsschweissen der Bereich 13a aufgefüllt werden.
Wenn dies erfolgt ist, d.h. eine Höhe des zweiten Basisteils 13b erreicht ist, wird das Auftragsschweissen auf die gesamte Oberfläche von 13b, 14 und 13a ausgedehnt. Man benötigt also kein vorgefertigtes Teil 13a.

Die oben anhand der FIG 1 und 2 beschriebenen besonders bevorzugten Ausführungsformen eines Herstellungsverfahrens für eine DS-/SX-Schaufel oder eine andere Turbinenkomponente sieht das Aufbringen von Aufbauteilen vor. Eine weitere bevorzugte Ausführungsform, die gegebenenfalls zusätzlich zur Weiterbildung der oben beschriebenen Turbinenkomponenten 9 und 10 angewendet werden kann, betrifft das Aufbringen von Schichten 16 mit einer kristallinen Vorzugsrichtung 17 auf eine Schaufel 18 als eine Turbinenkomponente gemäß FIG 3. Dadurch wird es möglich, beispielsweise so genannte Gradientenschaufeln herzustellen. Diese weisen in Abhängigkeit des Ortes auf einer Schaufel eine unterschiedliche Werkstoffzusammensetzung auf. Zum Beispiel kann eine solche Schaufel im Verankerungsbereich 20 gänzlich aus Metall hergestellt sein, jedoch in ihrer Ausdehnung 21 zur Spitze hin graduell mehr und mehr Keramik enthalten. Dies kann leicht dadurch erreicht werden, dass mehrere Lagen von Teilbereichen 19, die eine kristalline Vorzugsrichtung 17 aufweisen, aufgebracht werden. In FIG 3 ist ein einziger solcher Teilbereich 19 dargestellt. Dabei ändert sich von Lage zu Lage die Mischung aus Metall und Keramik derart, dass die Mischung hinsichtlich den Anforderungen, insbesondere den thermischen und mechanischen Anforderungen, an dem entsprechenden Ort der Schaufel optimiert wird. In dem vorliegenden Fall nimmt beispielsweise der Anteil an Keramik entlang der Ausdehnung 21 zur Spitze der Schaufel hin zu.

Eine weitere bevorzugte Möglichkeit, solch eine Gradientenschaufel herzustellen, besteht beispielsweise darin, einen so genannten Grünling oder Pressling bereitzustellen und dann schichtweise eine MCrAlY-Rinde anzubringen.

Die oben erläuterten Gradientenschaufeln sehen gemäß ihres Herstellungsverfahrens eine sich graduell ändernde Werkstoffzusammensetzung von Schicht zu Schicht vor. Genauso gut könnten jedoch auch Basisteile und Aufbauteile, wie sie beispielsweise anhand der FIG 1 und 2a bis 2c erläutert sind, entsprechend den Anforderungen jedes Teils hinsichtlich ihrer Werkstoffzusammensetzung optimiert und dann unter Erhaltung einer kristallinen Vorzugsrichtung im Fügebereich zusammengefügt werden.

Wie in der Beschreibung dargelegt, müssen Turbinenkomponenten hohen thermischen und mechanischen Belastungen standhalten. Es erweist sich deshalb als vorteilhaft, sie aus einem Material mit einer kristallinen Vorzugsrichtung herzustellen. Bisher werden die Turbinenkomponenten mit einer kristallinen Vorzugsrichtung als Ganzes hergestellt, wobei die Ausschussraten relativ hoch sind. Das vorgeschlagene Konzept ermöglicht die Herstellung einer bevorzugten Turbinenkomponente 9, 10 auf besonders einfache Weise, indem eine Turbinenkomponente 9, 10 mindestens aus einem Basisteil 1 und einem Aufbaumaterial 8 zusammengefügt wird, wobei der Teilbereich 7 der Fügezone eine kristalline Vorzugsrichtung 2 aufweist, so dass bisher vorhandene nachteilige Eigenschaften einer Fügezone ohne kristalline Vorzugsrichtung vermieden werden.

Die oben beschriebenen Verfahren stellen einige wesentliche Beispiele dar, welche verdeutlichen, dass das hier vorgeschlagene Konzept eine breite Variationsmöglichkeiten bietet, um selbst Turbinenkomponenten mit komplizierter Geometrie und unterschiedlichen Werkstoffzusammensetzungen für hohe thermische und mechanische Anforderungen besonders einfach und mit geringem Ausschuss herzustellen, zu reparieren oder anderweitig zu behandeln.

Die Erfindung funktioniert auch mittels Auftragsschweissen (siehe auch US-PS 6,024,792), bei dem zuerst das erste und/oder das zweite Basishilfsteil 4a, 4b (Fig. 1) bzw. das erste Basisteil 13a und Basishilfsteil (Fig. 2) an das Basisteil 1 bzw. an das zweite Basisteil 13b angebracht werden.
Dann erfolgt die Erzeugung des Aufbauteils 6, 15 mittels Auftragsschweissen.

Zusatzmaterial ist nicht immer notwendig.

Ebenso kann auf eine DS-Struktur eine SX-Struktur aufgebaut werden und umgekehrt.

## Patentansprüche

1. Verfahren zur Herstellung einer Turbinenkomponente (9, 10, 18),
wenigstens aus einem Basisteil (1, 13a, 13b) und Aufbaumaterial (8) oder einem Aufbauteil (15), aufweisend die Schritte:
Bereitstellen des Basisteils (1, 13a, 13b);
Anbringen eines Basishilfsteils (4a, 4b, 14) an das Basisteil (1, 13, 13b),
Aufbringen des Aufbaumaterials (8) oder des Aufbauteils (15) auf das Basisteil (1, 13a, 13b) und auf das Basishilfsteil (4a, 4b, 14)
Überführen des Aufbaumaterials (8) oder des Aufbauteils (15) mindestens in einem an das Basisteil (1, 13a,13b) grenzenden Teilbereich (7, 16c) von einem ersten Zustand in einen festen zweiten Zustand
und Erzeugung einer kristallinen Vorzugsrichtung auf dem Basisteil (1, 13a, 13b) und auf dem Basishilfsteil (4a, 4b, 14) in dem Aufbaumaterial (8) oder dem Teilbereich (16c),
wobei beim Überführen in dem Aufbaumaterial (8) oder in dem Material des Teilbereichs (16c) mindestens in dem Teilbereich (7, 16c) durch Basishilfsteile (4a, 4b) oder durch Basisteile (13a, 13b),
die als Keimbildner wirken,
eine kristalline Vorzugsrichtung (2, 12) initiiert wird, so dass nach dem Überführen das Aufbaumaterial (8) oder des Materials des Teilbereichs (16c) im festen zweiten Zustand mindestens in dem Teilbereich (7, 16c) die kristalline Vorzugsrichtung (2, 12) aufweist.

2. Verfahren nach Anspruch 1,
**dadurch gekennzeichnet, dass**
der erste Zustand ein flüssiger oder gasförmiger Zustand ist.

3. Verfahren nach Anspruch 1 oder 2,
**dadurch gekennzeichnet, dass**
das Aufbaumaterial (8) als eine oder mehrere Schichten von Zusatzmaterial (5) auf das Basisteil (1) aufgebracht wird und der Teilbereich (7) die eine oder mehrere Schichten Zusatzmaterial (5) und eine das Basisteil (1) verbindende Fügezone umfasst.

4. Verfahren nach Anspruch 1 oder 2,
**dadurch gekennzeichnet, dass**
das Aufbaumaterial (8) als ein Aufbauteil (6, 15) an das Basisteil (1, 13a, 13b) gesetzt wird und der Teilbereich (7, 16c) eine das Basisteil (1, 13a, 13b) und das Aufbauteil (6, 15) verbindende Fügezone bildet.

5. Verfahren nach Anspruch 4,
**dadurch gekennzeichnet, dass**
das Aufbaumaterial (8) ein zwischen dem Aufbauteil (6, 15) und Basisteil (1, 13a, 13b) angeordnetes und das Zusammenfügen des Aufbauteils (6, 15) und des Basisteils (1, 13a, 13b) unterstützendes Zusatzmaterial (5) umfasst.

6. Verfahren nach einem der Ansprüche 1 bis 5,
**dadurch gekennzeichnet, dass**
das Basisteil (1, 13a, 13b) und/oder das Aufbaumaterial (8) mindestens an der an den Teilbereich (7) grenzenden Oberfläche eine kristalline Vorzugsrichtung (2) aufweist.

7. Verfahren nach einem der Ansprüche 1 bis 6,
**dadurch gekennzeichnet, dass**
die kristalline Vorzugsrichtung (2) als gerichtet erstarrte und/oder Einkristall-Struktur ausgebildet ist.

8. Verfahren nach einem der Ansprüche 1 bis 7,
**dadurch gekennzeichnet, dass**
das Überführen durch Kühlen mindestens des Teilbereichs (7) beschleunigt wird.

9. Verfahren nach Anspruch 3 oder 5,
**dadurch gekennzeichnet, dass**
das Aufbaumaterial (8) oder das Aufbauteil (15) im Rahmen eines Schweißvorgangs und/oder Umschmelzvorgangs mit Zusatzmaterial (5) aufgebracht wird,
wobei der erste Zustand des Zusatzmaterials (5) ein flüssiger Zustand ist.

10. Verfahren nach Anspruch 3 oder 5,
**dadurch gekennzeichnet, dass**
das Zusatzmaterial (5) als Pulver aufgebracht wird, wobei der erste Zustand des Zusatzmaterials (5) ein erster fester Zustand ist oder im Rahmen eines Spritz-, Pinsel- oder Tauchvorgangs aufgebracht wird, wobei der erste Zustand des Zusatzmaterials (5) ein flüssiger Zustand ist.

11. Verfahren nach Anspruch 3 oder 5,
**dadurch gekennzeichnet, dass**
das Aufbaumaterial (8) als Folie, Blech oder Draht aufgebracht wird,
wobei der erste Zustand des Zusatzmaterials (5) ein flüssiger Zustand ist.

12. Verfahren nach Anspruch 3 oder 5,
**dadurch gekennzeichnet, dass**
das Zusatzmaterial (5) epitaktisch aufgebracht wird, wobei der erste Zustand des Zusatzmaterials (5) ein gasförmiger Zustand ist.

13. Verfahren nach einem der Ansprüche 1 bis 8,
**dadurch gekennzeichnet, dass**
das Aufbaumaterial (8) im Rahmen eines Gießvorgangs aufgebracht wird, wobei der erste Zustand des Aufbaumaterials (8) ein flüssiger Zustand ist.

14. Verfahren nach einem der Ansprüche 1 bis 13,
**dadurch gekennzeichnet, dass**
das Basisteil (1) und/oder ein Basishilfsteil (4a, 4b, 14) zur Fertigstellung der Turbinenkomponente (9, 10) wieder abgetragen wird.

15. Vorrichtung zur Herstellung einer Turbinenkomponente (9, 10),
wenigstens aus einem Basisteil (1, 13a, 13b) und Aufbaumaterial (8) oder einem Aufbauteil (15), aufweisend:
eine Halterung zum Bereitstellen des Basisteils (1, 13a, 13b);
wobei Basishilfsteile (4a, 4b, 14) an das Basisteil (1, 13a ,13b) anbringbar sind;
eine Aufbringvorrichtung zum Aufbringen des Aufbaumaterials (8) oder des Aufbauteils (15) auf das Basisteil (1, 13a, 13b) und auf ein Basishilfsteil (4a, 4b, 14) und zum Überführen des Aufbaumaterials (8) oder des Aufbauteils (15) mindestens in einem an das Basisteil (1, 13a, 13b) grenzenden Teilbereich (7, 16c) von einem ersten Zustand in einen festen zweiten Zustand,
wobei die an den Teilbereich (7, 16c) grenzende Oberfläche des Basisteils (1, 13a, 13b) als Keimbildner für die kristalline Vorzugsrichtung (2) wirkt.

16. Vorrichtung nach Anspruch 15,
**dadurch gekennzeichnet, dass**
die Halterung zum Bereitstellen des Basisteils (1, 13a, 13b) und/oder eines Basishilfsteils (4a, 4b, 14) ein Schweißbad ist,
bei dem das Basisteil (1, 13a, 13b) und/oder das Basishilfsteil (4a, 4b, 14) als eine Schweißbadsicherung ausgebildet ist.

17. Vorrichtung nach einem der Ansprüche 15 oder 16,
**dadurch gekennzeichnet, dass**
die Aufbringvorrichtung eine Vorrichtung aus der Gruppe bestehend aus: Schweißvorrichtung, Umschmelzvorrichtung, Auftragvorrichtung und Gießvorrichtung ist.

18. Vorrichtung nach einem der Ansprüche 15 bis 17,
**dadurch gekennzeichnet, dass**
zum Überführen des Aufbaumaterials (8) eine Kühlung vorgesehen ist.

19. Verwendung der Vorrichtung nach einem der Ansprüche 15 bis 18
zur Reparatur und/oder Beschichtung einer Turbinenkomponente (9, 10 18).

20. Turbinenkomponente (9, 10, 18) mit einem Basisteil (1, 13a, 13b) und Basishilfsteile (4a, 4b, 14)
wobei das Basisteil (1, 13a, 13b) und Basishilfsteile (4a, 4b, 14) Aufbaumaterial (8) oder ein Aufbauteil (15) aufweisen,
das von einem ersten Zustand in einen festen zweiten Zustand unter Initiierung einer kristallinen Vorzugsrichtung (2) durch einen separaten Keimbildner überführt ist,
so dass nach dem Überführen mindestens der Teilbereich (7 16c) die kristalline Vorzugsrichtung (2) aufweist,
wobei bei der Herstellung als Keimbildner für die kristalline Vorzugsrichtung (2) die an den Teilbereich (7, 16c) grenzende Oberfläche eines Basisteils (1, 13a, 13b) und/oder Basishilfsteile (4a, 4b) wirken.

21. Turbinenkomponente nach Anspruch 20,
**dadurch gekennzeichnet, dass**
der Teilbereich (7, 16c) an ein Aufbauteil (6, 15) grenzt, das mindestens in einem an den Teilbereich (7, 16c) grenzenden Bereich die kristalline Vorzugsrichtung (2) aufweist.

22. Turbinenkomponente nach Anspruch 20 oder 21,
**dadurch gekennzeichnet, dass**
der Teilbereich (7, 16c) an ein Basisteil (1, 13a, 13b) grenzt,
das mindestens in einem an den Teilbereich (7, 16c) grenzenden Bereich die kristalline Vorzugsrichtung (2) aufweist.

## Claims

1. Process for producing a turbine component (9, 10, 18), at least comprising a base part (1, 13a, 13b) and build-up material (8) or a build-up part (15), including the following steps:
provision of the base part (1, 13a, 13b);
fitting of an auxiliary base part (4a, 4b, 14) to the base part (1, 13, 13b),
application of the build-up material (8) or the build-up part (15) to the base part (1, 13a, 13b) and to the auxiliary base part (4a, 4b, 14),
conversion of the build-up material (8) or the build-up part (15), at least in a subregion (7, 16c) which adjoins the base part (1, 13a, 13b), from a first state into a solid second state,
and producing a preferred crystalline orientation on the base part (1, 13a, 13b) and on the auxiliary base part (4a, 4b, 14) in the build-up material (8) or the subregion (16c),
wherein during the conversion in the build-up material (8) or in the material of the subregion (16c), at least in the subregion (7, 16c),
a preferred crystalline orientation (2, 12) is initiated by auxiliary base parts (4a, 4b) or by base parts (13a, 13b) which act as nucleating agents,
so that after the conversion of the build-up material (8) or the material of the subregion (16c), in the solid second state, at least in the subregion (7, 16c), has the preferred crystalline orientation (2, 12).

2. Process according to Claim 1, **characterized in that** the first state is a liquid or gaseous state.

3. Process according to Claim 1, **characterized in that** the build-up material (8) is applied to the base part (1) as one or more layers of filler material (5), and the subregion (7) comprises the one or more layers of filler material (5) and a joining zone which connects the base part (1).

4. Process according to Claim 1,
**characterized in that** the build-up material (8) is placed onto the base part (1, 13a, 13b) as a build-up part (6, 15), and the subregion (7, 16c) forms a joining zone which connects the base part (1, 13a, 13b) and the build-up part (6, 15).

5. Process according to Claim 4, **characterized in that** the build-up material (8) comprises a filler material (5) which is arranged between the build-up part (6, 15) and base part (1, 13a, 13b) and helps with the joining of the build-up part (6, 15) and the base part (1, 13a, 13b).

6. Process according to one of Claims 1 to 5, **characterized in that** the base part (1, 13a, 13b) and/or the build-up material (8) has a preferred crystal orientation (2) at least at the surface which adjoins the subregion (7).

7. Process according to one of Claims 1 to 6, **characterized in that** the preferred crystal orientation (2) is formed as a directionally solidified structure and/or a single crystal structure.

8. Process according to one of Claims 1 to 7, **characterized in that** the conversion step is accelerated by cooling at least the subregion (7).

9. Process according to Claim 3 or 5, **characterized in that** the build-up material (8) or the build-up part (15) is applied together with filler material (5) as part of a welding operation and/or a remelting operation, the first state of the filler material (5) being a liquid state.

10. Process according to Claim 3 or 5, **characterized in that** the filler material (5) is applied as a powder, in which case the first state of the filler material (5) is a first solid state, or is applied as part of a spraying, brushing or dipping operation, in which case the first state of the filler material (5) is a liquid state.

11. Process according to Claim 3 or 5, **characterized in that** the build-up material (8) is applied in the form of a foil, sheet or wire, in which case the first state of the filler material (5) is a liquid state.

12. Process according to Claim 3 or 5, **characterized in that** the filler material (5) is applied epitaxially, in which case the first state of the filler material (5) is a gaseous state.

13. Process according to one of Claims 1 to 8, **characterized in that** the build-up material (8) is applied as part of a casting operation, in which case the first state of the build-up material (8) is a liquid state.

14. Process according to one of Claims 1 to 13, **characterized in that** the base part (1) and/or an auxiliary base part (4a, 4b, 14) is removed again to complete the turbine component (9, 10) .

15. Apparatus for producing a turbine component (9, 10), at least comprising a base part (1, 13a, 13b) and build-up material (8) or a build-up part (15), including:
a holder for providing the base part (1, 13a, 13b);
in which auxiliary base parts (4a, 4b, 14) can be fitted to the base part (1, 13a, 13b);
an application device for applying the build-up material (8) or the build-up part (15) to the base part (1, 13a, 13b) and to an auxiliary base part (4a, 4b, 14) and for converting the build-up material (8) or the build-up part (15) from a first state into a solid second state at least in a subregion (7, 16c) which adjoins the base part (1, 13a, 13b);
the surface of the base part (1, 13a, 13b) which adjoins the subregion (7, 16c) acting as a nucleating agent for the preferred crystal orientation (2).

16. Apparatus according to Claim 15, **characterized in that** the holder for providing the base part (1, 13a, 13b) and/or an auxiliary base part (4a, 4b, 14) is a weld pool, in which the base part (1, 13a, 13b) and/or the auxiliary base part (4a, 4b, 14) is formed as a weld pool backup.

17. Apparatus according to one of Claims 15 or 16, **characterized in that** the application device is a device selected from the group consisting of a welding device, a remelting device, a build-up device and a casting device.

18. Apparatus according to one of Claims 15 to 17, **characterized in that** a cooling means is provided for conversion of the build-up material (8).

19. Use of the apparatus according to one of Claims 15 to 18 for repairing and/or coating a turbine component (9, 10, 18).

20. Turbine component (9, 10, 18) having a base part (1, 13a, 13b) and auxiliary base parts (4a, 4b, 14)
wherein the base part (1, 13a, 13b) and auxiliary base parts (4a, 4b, 14) have build-up material (8) or a build-up part (15),
which has been converted from a first state into a solid second state, with initiation of a preferred crystal orientation (2) by a separate nucleating agent,
so that after the conversion step at least the subregion (7, 16c) has the preferred crystal orientation (2),
wherein during production, that surface of a base part (1, 13a, 13b) and/or auxiliary base parts (4a, 4b) which adjoins the subregion (7, 16c) acts as a nucleating agent for the preferred crystal orientation (2).

21. Turbine component according to Claim 20, **characterized in that** the subregion (7, 16c) adjoins a build-up part (6, 15) which has the preferred crystal orientation (2) at least in a region which adjoins the subregion (7, 16c).

22. Turbine component according to Claim 20 or 21, **characterized in that** the subregion (7, 16c) adjoins a base part (1, 13a, 13b) which has the preferred crystal orientation (2) at least in a region which adjoins the subregion (7,16c).

## Revendications

1. Procédé de fabrication d'un élément ( 9, 10, 18 ) de turbine,
constitué d'au moins une partie ( 1, 13a, 13b ) de base et d'une matière ( 8 ) de structure ou d'une partie ( 15 ) de structure, ayant les stades dans lesquels :
on se procure la partie ( 1, 13a, 13b ) de base ;
on met une partie ( 4a, 4b, 14 ) auxiliaire de base sur la partie ( 1, 13a, 13b ) de base ;
on dépose la matière ( 8 ) de structure ou la partie ( 15 ) de structure sur la partie ( 1, 13a, 13b ) de base et sur la partie ( 4a, 4b, 14 ) auxiliaire de base ;
on transforme la matière ( 8 ) de structure ou la pièce ( 15 ) de structure au moins dans une zone ( 7, 16c ) partielle délimitant la partie ( 1, 13a, 13b ) de base en le faisant passer d'un premier état à un deuxième état solide ;
et on produit une direction cristalline préférentielle sur la partie ( 1, 13a, 13b ) de base et sur la partie ( 4a, 4b, 14 ) auxiliaire de base dans la matière ( 8 ) de structure ou dans la zone ( 16c ) partielle ;
dans lequel, pour la transformation dans la matière ( 8 ) de structure ou dans la matière de la zone ( 16c ) partielle, on initie au moins dans la zone ( 7, 16c ) par des parties ( 4a, 4b ) auxiliaires de base ou par des parties ( 13a, 13b ) de base,
qui servent d'agent de nucléation ;
une direction ( 2, 12 ) cristalline préférentielle de sorte qu'après la transformation de la matière ( 8 ) de structure ou la matière de la zone ( 16c ) partielle en le deuxième état solide il y a au moins dans la zone ( 7, 16c ) partielle la direction ( 2, 12 ) cristalline préférentielle.

2. Procédé suivant la revendication 1,
**caractérisé en ce que** le premier état est un état liquide ou un état gazeux.

3. Procédé suivant la revendication 1 ou 2,
**caractérisé en ce que** l'on dépose la matière ( 8 ) de structure sous la forme d'une couche ou de plusieurs couches de matière ( 5 ) supplémentaires sur la partie ( 1 ) de base et la partie ( 7 ) partielle comprend la couche ou les plusieurs couches de matière ( 5 ) supplémentaires et une zone de jonction reliant la partie ( 1 ) de base.

4. Procédé suivant la revendication 1 ou 2,
**caractérisé en ce que** la matière ( 8 ) de structure est mise en tant que partie ( 6, 15 ) de structure sur la partie ( 1, 13a, 13b ) de base et la zone ( 7, 16c ) partielle forme une zone de jonction reliant la partie ( 1, 13a, 13b ) et la partie ( 6, 15 ) de structure.

5. Procédé suivant la revendication 4,
**caractérisé en ce que** la matière ( 8 ) de structure comprend une matière ( 5 ) supplémentaire disposée entre la partie ( 6, 15 ) de structure et la partie ( 1, 13a, 13b ) de base et favorisant la jonction de la partie ( 6, 15 ) de structure et de la partie ( 1, 13a, 13b ) de base.

6. Procédé suivant l'une des revendications 1 à 5,
**caractérisé en ce que** la partie ( 1, 13a, 13b ) de base et/ou la matière ( 8 ) de structure a une direction ( 2 ) cristalline préférentielle au moins à la surface délimitant la zone ( 7 ) partielle.

7. Procédé suivant l'une des revendications 1 à 6,
**caractérisé en ce que** la direction ( 2 ) cristalline préférentielle est constituée sous la forme d'une structure à solidification dirigée et/ou monocristalline.

8. Procédé suivant l'une des revendications 1 à 7,
**caractérisé en ce que** l'on accélère la transformation en refroidissant ou moins la zone ( 7 ) partielle.

9. Procédé suivant la revendication 3 ou 5,
**caractérisé en ce que** l'on dépose la matière ( 8 ) de structure ou la partie ( 15 ) de structure dans le cadre d'une opération de soudage et/ou d'une opération de refusion avec de la matière ( 5 ) supplémentaire,
le premier état de la matière ( 5 ) supplémentaire étant un état liquide.

10. Procédé suivant la revendication 3 ou 5,
**caractérisé en ce que** l'on dépose la matière ( 5 ) supplémentaire sous la forme d'une poudre, le premier état de la matière ( 5 ) supplémentaire étant un premier état solide ou étant déposé dans le cadre d'une opération de projection au pinceau ou d'immersion, le premier état de la matière ( 5 ) supplémentaire étant un état liquide.

11. Procédé suivant la revendication 3 ou 5,
**caractérisé en ce que** l'on dépose la matière ( 8 ) de structure sous la forme d'une feuille, d'une tôle ou d'un fil,
le premier état de la matière ( 5 ) supplémentaire étant un état liquide.

12. Procédé suivant la revendication 3 ou 5,
**caractérisé en ce que** l'on dépose la matière ( 5 ) supplémentaire par épitaxie, le premier état de la matière ( 5 ) supplémentaire étant un état gazeux.

13. Procédé suivant l'une des revendications 1 à 8,
**caractérisé en ce que** l'on dépose la matière ( 8 ) de structure dans le cadre d'une opération de coulée, le premier état de la matière ( 8 ) de structure étant un état liquide.

14. Procédé suivant l'une des revendications 1 à 13,
**caractérisé en ce que** l'on retire la partie ( 1 ) de base et/ou une partie ( 4a, 4b, 14 ) auxiliaire de base pour finir l'élément ( 9, 10 ) constitutif de turbine.

15. Dispositif de fabrication d'un élément ( 9, 10 ) constitutif de turbine,
constitué d'au moins une partie ( 1, 13a, 13b ) de base et d'une matière ( 8 ) de structure ou d'une partie ( 15 ) de structure,
comprenant :
une fixation pour disposer de la partie ( 1, 13a, 13b ) de base ;
dans lequel des parties ( 4a, 4b, 14 ) auxiliaires de base peuvent être mises sur la partie ( 1, 13a, 13b ) de base ;
un dispositif de dépôt de la matière ( 8 ) de base ou de la partie ( 15 ) de structure sur la partie ( 1, 13a, 13b ) de base et sur une partie ( 4a, 4b, 14 ) auxiliaire de base et pour faire passer la matière ( 8 ) de structure ou la partie ( 15 ) de structure au moins dans une zone ( 7, 16c ) partielle délimitant la partie ( 1, 13a, 13b ) de base d'un premier état en un deuxième état solide,
dans lequel la surface, délimitant la zone ( 7, 16c ) partielle, de la partie ( 1, 13a, 13b ) de base agit en tant qu'agent de nucléation pour la direction ( 2 ) cristalline préférentielle.

16. Dispositif suivant la revendication 15,
**caractérisé en ce que** la fixation pour disposer de la partie ( 1, 13a, 13b ) de base et/ou d'une partie ( 4a, 4b, 14 ) auxiliaire de base est un bain de soudure ;
dans lequel la partie ( 1, 13a, 13b ) de base et/ou la partie ( 4a, 4b, 14 ) de base est constituée sous la forme d'une fixation par bain de soudure.

17. Dispositif suivant l'une des revendications 15 ou 16,
**caractérisé en ce que** le dispositif de dépôt est un dispositif choisi dans le groupe constitué par un dispositif de soudage, un dispositif de refusion, un dispositif de dépôt et un dispositif de coulée.

18. Dispositif suivant l'une des revendications 15 à 17,
**caractérisé en ce qu'**il est prévu un refroidissement pour la transformation de la matière ( 8 ) de structure.

19. Utilisation du dispositif suivant l'une des revendications 15 à 18,
pour réparer et/ou revêtir un élément ( 9, 10, 18 ) constitutif de turbine.

20. Élément ( 9, 10, 18 ) constitutif de turbine comprenant une partie ( 1, 13a, 13b ) de base et des parties ( 4a, 4b, 14 ) auxiliaire de base ;
la partie ( 1, 13a, 13b ) de base et des parties ( 4a, 4b, 14 ) auxiliaires de base ayant une matière ( 8 ) de structure ou une partie ( 15 ) de structure,
qui est transformée d'un premier état en un deuxième état solide par initiation d'une direction ( 2 ) cristalline préférentielle par un agent de nucléation distinct de sorte qu'après la transformation au moins la zone ( 7, 16c ) partielle a la direction ( 2 ) cristalline préférentielle, dans lequel, lors de la fabrication la surface, voisine de la zone ( 7, 16c ) partielle, d'une partie ( 1, 13a, 13b ) de base et/ou de parties ( 4a, 4b ) de base agissent en tant qu'agent de nucléation pour la direction ( 2 ) cristalline préférentielle.

21. Élément de turbine suivant la revendication 20,
**caractérisé en ce que** la zone ( 7, 16c ) partielle est voisine d'une partie ( 6, 15 ) de structure, qui a, au moins dans une zone voisine de la zone ( 7, 16c ) partielle, la direction ( 2 ) cristalline préférentielle.

22. Élément de turbine suivant la revendication 20 ou 21,
**caractérisé en ce que** la zone ( 7, 16c ) partielle est voisine d'une partie ( 1, 13a, 13b ) de base,
qui a, au moins dans une zone voisine de la zone ( 7, 16c ) partielle, la direction ( 2 ) cristalline préférentielle.
